# EUROPEAN PATENT APPLICATION

(11) **EP 3 229 110 A1**
(43) Date of publication of application: **11.10.2017**
(21) Application number: 16746315.7
(22) Date of filing: 02.02.2016
(51) Int. Cl.: G06F 3/02, G06F 3/023, H01H 13/00, H01H 13/78, H03M 11/04, H03M 11/14

(54) **TOUCH PANEL WITH PUSH BUTTON**

(30) Priority: 05.02.2015 JP 2015021285
(71) Applicant: Panasonic Intellectual Property Management Co., Ltd., Osaka-shi, Osaka 540-6207 (JP)
(72) Inventor: MORIYASU, Takayoshi, Osaka 540-6207 (JP)
(74) Representative: Eisenführ Speiser
(86) International application number: PCT/JP2016/000517
(87) International publication number: WO 2016/125483

(57) **Abstract**

Provided is a technique for preventing degradation in design quality while maintaining operability. A fixing member is disposed on an operation surface side of a touch panel, and a cover panel is disposed on an operation surface side of the fixing member. The cover panel has a cover-panel through hole, and the fixing member has a fixing-member through hole that is wider than the cover-panel through hole. A push button part is disposed in the cover-panel through hole. The push button part includes a switch part having a base part and a switch surface part, and a pressing part. The base part is disposed between the cover panel and the touch panel, in the fixing-member through hole, and the switch surface part protrudes from an inner edge of the base part toward an inside of the cover-panel through hole. The pressing part is fixed to the switch surface part from a side opposite to the touch panel.

## Description

### TECHNICAL FIELD

The present invention relates to a vehicle-mounted device, and particularly to a push button-equipped touch panel provided in the vehicle-mounted device.

### BACKGROUND ART

A compact electronic device such as a mobile telephone device is limited in size, in order not to spoil its portability. In order to flexibly carry out an input operation under such a situation, a touch panel capable of changing display of key tops is used. However, upon operating the touch panel, click feeling as in a physical button cannot be obtained. To cope with this problem, key tops are provided on a surface of a panel (for example, see PTL 1).

### Citation List

### Patent Literature

PTL 1: Unexamined Japanese Patent Publication No. 2010-176552

### SUMMARY OF THE INVENTION

An object of the present invention is to provide a technique for preventing degradation in design quality while maintaining operability. A push button-equipped touch panel according to one aspect of the present invention includes: a touch panel; a cover panel that is disposed on an operation surface side of the touch panel and that has a through hole; and a push button part disposed in the through hole of the cover panel.

According to the present invention, the degradation in the design quality can be prevented while maintaining the operability.

### BRIEF DESCRIPTION OF DRAWINGS

FIG. 1 is an external view of a vehicle interior, viewed from a rear side, where a vehicle-mounted device according to a first exemplary embodiment of the present invention is mounted.
FIG. 2 illustrates a configuration of the vehicle-mounted device in FIG. 1.
FIG. 3 is a perspective view illustrating an external appearance of the vehicle-mounted device in FIG. 1.
FIG. 4 is a perspective view illustrating a configuration in which a push button-equipped touch panel in FIG. 3 is disassembled.
FIG. 5 is a front view illustrating a configuration of the push button-equipped touch panel in FIG. 4.
FIG. 6 is a cross-sectional view illustrating the configuration of the push button-equipped touch panel in FIG. 5.
FIG. 7 is a cross-sectional view illustrating a configuration in a state where a pressing part in FIG. 6 is pressed down.
FIG. 8A is a cross-sectional view illustrating a configuration of a variation of the push button-equipped touch panel in FIG. 6.
FIG. 8B is a cross-sectional view illustrating a configuration of a variation of the push button-equipped touch panel in FIG. 6.
FIG. 9 is a partial cross-sectional view illustrating a configuration of a push button-equipped touch panel according to a second exemplary embodiment of the present invention.
FIG. 10 is a cross-sectional view illustrating a configuration of a push button-equipped touch panel according to a third exemplary embodiment of the present invention.

### DESCRIPTION OF EMBODIMENTS

Prior to a description of exemplary embodiments of the present invention, a problem in a conventional touch panel will be briefly described. Key tops provided on a surface of the touch panel adversely affect flat design of the touch panel, thereby greatly spoiling design quality.

### FIRST EXEMPLARY EMBODIMENT

Prior to a specific description of a first exemplary embodiment of the present invention, an outline of the first exemplary embodiment will be described. The first exemplary embodiment of the present invention relates to a vehicle-mounted device mounted on a vehicle. The vehicle-mounted device employs an electrostatic capacitance type touch panel to achieve input operations corresponding to various displays and advanced flat design. However, as described above, the electrostatic capacitance type touch panel has a flat operation surface and does not provide click feeling upon operation as in a physical button. Therefore, it is difficult to perform operation with a little movement of line of sight, and is prone to cause unintended operation or erroneous operation such as pressing the operation surface twice. In order to prevent degradation in design quality while solving these problems, the first exemplary embodiment is configured as below.

In the first exemplary embodiment, a cover panel is disposed on an operation surface side of the electrostatic capacitance type touch panel, and a through hole that reaches the electrostatic capacitance type touch panel is provided in the cover panel. A push button part is disposed in the through hole, and a surface of the push button part and a surface of the cover panel are flush with each other. Operability is improved by disposing the push button part, and the flat design is also maintained by the push button part and the cover panel.

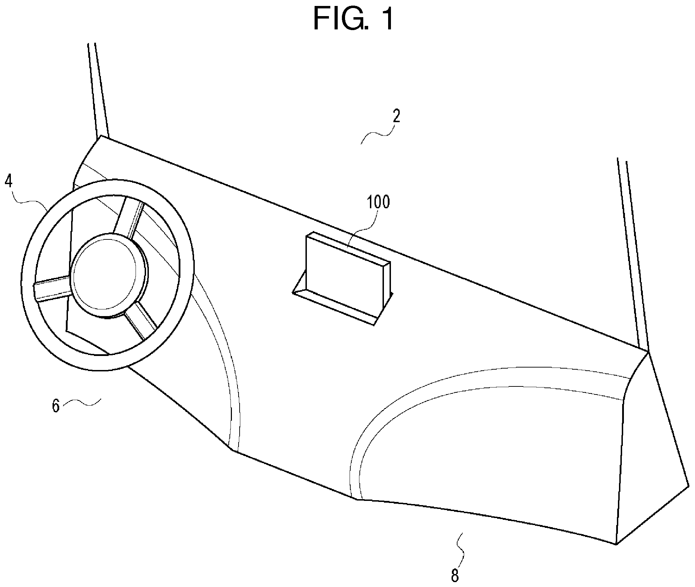

FIG. 1 is an external view of a vehicle interior, viewed from a rear side, where vehicle-mounted device 100 according to the first exemplary embodiment of the present invention is mounted. In a front portion of the vehicle interior, driver's seat 6 is disposed on a left side, passenger seat 8 is disposed on a right side, and steering wheel 4 is disposed in front of driver's seat 6. Steering wheel 4 and driver's seat 6 are disposed on the left side in FIG. 1, but steering wheel 4 and driver's seat 6 may be disposed on the right side. Furthermore, windshield 2 is disposed in front of steering wheel 4. Vehicle-mounted device 100 is disposed in a center console, which is disposed at a side, for example a right side, of steering wheel 4. Vehicle-mounted device 100 displays, for example, an image of a car navigation system.

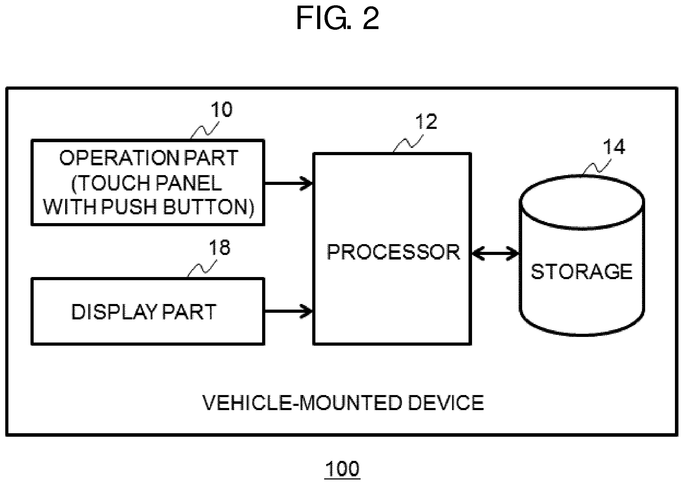

FIG. 2 illustrates a configuration of vehicle-mounted device 100. Vehicle-mounted device 100 includes push button-equipped touch panel 10, display part 18, processor 12, and storage 14. Storage 14 is a storage medium such as a hard disk and stores digital data such as map data and music data. Processor 12 performs predetermined processing of vehicle-mounted device 100. For example, processor 12 performs navigation processing by using the map data stored in storage 14. Also, processor 12 performs music playback processing by using the music data stored in storage 14. Known techniques may be used for these processing, and therefore a description thereof is omitted herein. Further, the predetermined processing performed by processor 12 may include processing other than the above processing.

Push button-equipped touch panel 10 is a user interface that receives an instruction from a user through a touch operation performed by the user, and outputs the received instruction to processor 12. Display part 18 receives image data from processor 12, and displays the received image data. The instruction output from push button-equipped touch panel 10 to processor 12 is used for the predetermined processing in processor 12, and the image data output from processor 12 to display part 18 is generated through the predetermined processing in processor 12. A configuration of push button-equipped touch panel 10 will be described later.

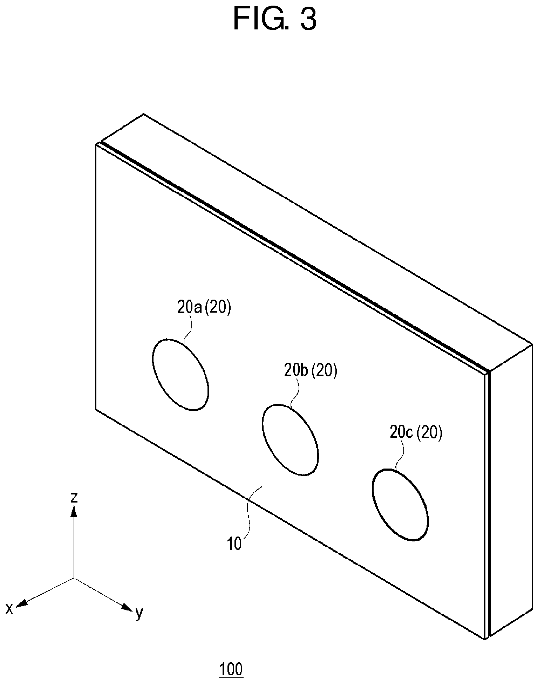

FIG. 3 is a perspective view illustrating an external appearance of vehicle-mounted device 100. As illustrated in FIG. 3, a rectangular coordinate system with an x axis, a y axis, and a z axis is defined. The y axis and the z axis are orthogonal to each other in a plane of push button-equipped touch panel 10 mounted on vehicle-mounted device 100. The x axis is perpendicular to the y axis and the z axis, and extends in a thickness direction of vehicle-mounted device 100. A positive direction of each of the x axis, the y axis, and the z axis is defined as a direction indicated by a corresponding arrow in FIG. 3, and a negative direction is defined as a direction opposite to the arrow. Here, the positive direction of the x axis is a direction toward driver's seat 6 and passenger seat 8 in FIG. 1, and may be referred to as a "front surface side" or an "operation surface side". The negative direction of the x axis is a direction toward windshield 2 in FIG. 1, and may be referred to as a "rear surface side". Further, the positive direction of the z axis may be referred to as an "upper surface side", and the negative direction of the z axis may be referred to as a "lower surface side".

As described above, vehicle-mounted device 100 includes push button-equipped touch panel 10, and push button-equipped touch panel 10 includes first push button part 20a, second push button part 20b, and third push button part 20c, which are collectively referred to as push button parts 20. Push button parts 20 are physical buttons, and are pressed down by the user. In this case, a number of push button parts 20 is three, but the number of push button parts 20 is not limited thereto. Further, a shape of each of push button parts 20 in a plan view is not limited to a circle, and can be selected freely from, for example, polygons such as a triangle and a square. Push button-equipped touch panel 10 is configured by a touch panel, and therefore can receive touch operations performed by the user, even in regions where push button parts 20 are not disposed.

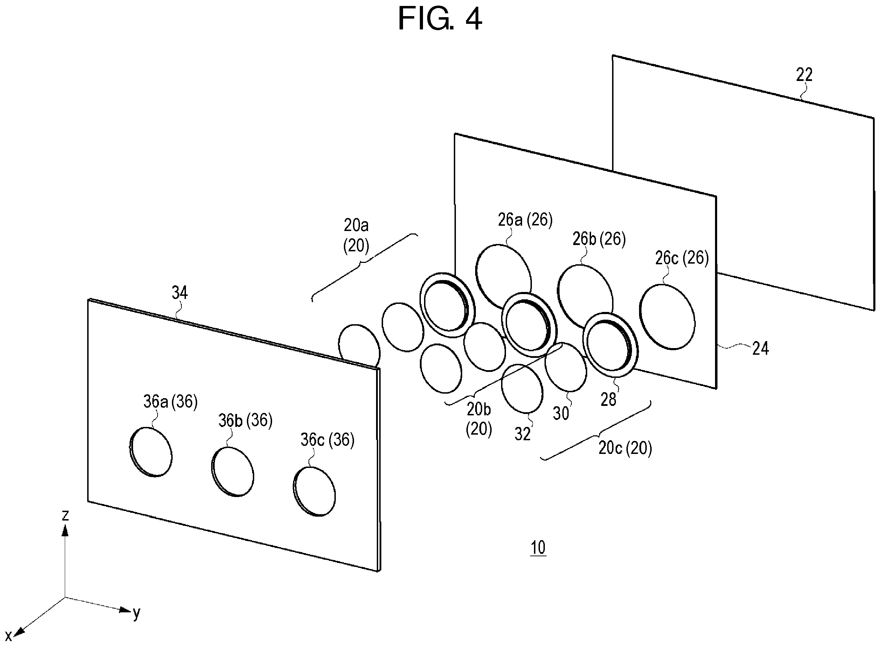

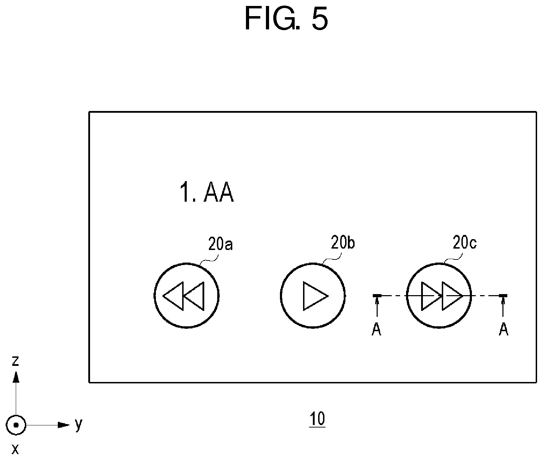

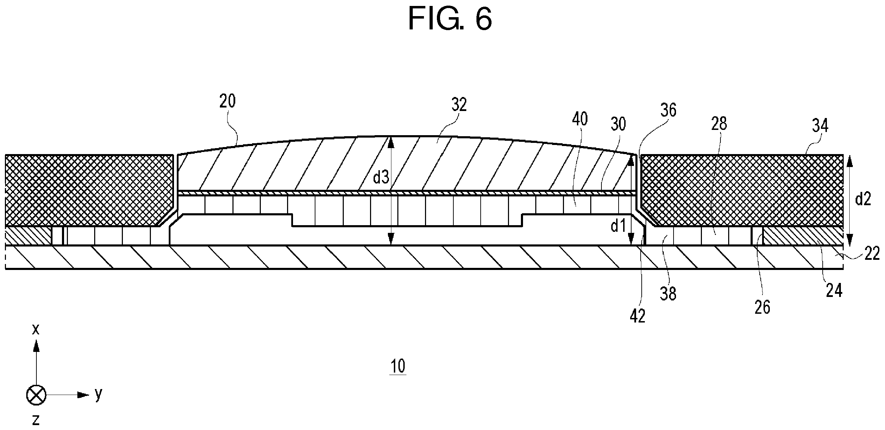

FIG. 4 is a perspective view illustrating a configuration in which push button-equipped touch panel 10 is disassembled. FIG. 5 is a front view illustrating a configuration of push button-equipped touch panel 10. FIG. 6 is a cross-sectional view illustrating the configuration of push button-equipped touch panel 10. Push button-equipped touch panel 10 includes touch panel 22, fixing member 24, push button parts 20, and cover panel 34. Fixing member 24 has first fixing-member through hole 26a, second fixing-member through hole 26b, and third fixing-member through hole 26c, which are collectively referred to as fixing-member through holes 26. Each of push button parts 20 includes switch part 28, fixing member 30, and pressing part 32. Cover panel 34 has first cover-panel through hole 36a, second cover-panel through hole 36b, and third cover-panel through hole 36c, which are collectively referred to as cover-panel through holes 36. Further, switch part 28 has base part 38, switch surface part 40, and bent part 42.

Touch panel 22 is the electrostatic capacitance type touch panel having a rectangular shape in a y-z plane. Known techniques may be used for the electrostatic capacitance type touch panel, and therefore a description thereof is omitted herein. Hereinafter, a surface on an operation surface side of touch panel 22 is referred to as an "operation surface of touch panel 22". Fixing member 24 is an optically transparent double-sided tape or an optically transparent resin having a rectangular shape similar to touch panel 22. Fixing member 24 fixes cover panel 34, to be described later, to the operation surface side of touch panel 22. Therefore, fixing member 24 is interposed between touch panel 22 and cover panel 34. Further, fixing member 24 has fixing-member through holes 26 penetrating in the x axis direction. In this case, three fixing-member through holes 26 including first fixing-member through hole 26a to third fixing-member through hole 26c are arranged in the y axis direction. It is noted that a number of fixing-member through holes 26 is not limited to three. A shape of each of fixing-member through holes 26 in a plan view is not limited to a circle, and can be selected freely from, for example, polygons such as a triangle and a square. Furthermore, fixing-member through holes 26 are not limited to be arranged in the y axis direction, and may be arranged in the z axis direction, and not necessarily aligned in a row.

Cover panel 34 has a rectangular shape similar to touch panel 22 and fixing member 24. In FIG. 3 and FIG. 4, an outer shape of cover panel 34 is illustrated in the same size as outer shapes of touch panel 22 and fixing member 24 for simplicity. However, cover panel 34 is a design component, and therefore both the shape and the size of cover panel 34 can be designed freely in practice. Since a screen outer frame and the like are disposed around touch panel 22, the size of cover panel 34 is generally larger than the size of touch panel 22. The shape of cover panel 34 is also not limited to a rectangle. Cover panel 34 is bonded to an operation surface side of fixing member 24, and therefore is disposed on the operation surface side of touch panel 22. Hereinafter, a surface on an operation surface side of cover panel 34 is referred to as an "operation surface of cover panel 34". Further, cover panel 34 is provided with cover-panel through holes 36 penetrating in the x axis direction. In this case, three cover-panel through holes 36 including first cover-panel through hole 36a to third cover-panel through hole 36c are arranged in the y axis direction. It is noted that a number of cover-panel through holes 36 is not limited to three. Further, a shape of each of cover-panel through holes 36 in a plan view is not limited to a circle, and can be selected freely from, for example, polygons such as a triangle and a square. Furthermore, cover-panel through holes 36 are not limited to be arranged in the y axis direction, and may be arranged in the z axis direction, and not necessarily aligned in a row.

First cover-panel through hole 36a is disposed so as to overlap with first fixing-member through hole 26a. Further, both first fixing-member through hole 26a and first cover-panel through hole 36a have a circular shape in the y-z plane. Furthermore, first fixing-member through hole 26a is set to be wider than first cover-panel through hole 36a. In other words, first fixing-member through hole 26a has a larger diameter than that of first cover-panel through hole 36a. Therefore, first cover-panel through hole 36a is disposed at a central portion of first fixing-member through hole 26a. Second cover-panel through hole 36b and second fixing-member through hole 26b are configured in a similar manner, and third cover-panel through hole 36c and third fixing-member through hole 26c are also configured in a similar manner.

First push button part 20a is disposed in a through hole constituted by first cover-panel through hole 36a and first fixing-member through hole 26a. Second push button part 20b and third push button part 20c are disposed in a similar manner. FIG. 5 illustrates a display of push button-equipped touch panel 10 when the music playback processing is performed in vehicle-mounted device 100. Each of push button parts 20 has a circular shape, and a mark indicating an operation of the music playback processing is displayed at a region immediately below each of push button parts 20 in display part 18. For example, a mark indicating an operation of "rewinding" is displayed at first push button part 20a, a mark indicating an operation of "playback" is displayed at second push button part 20b, and a mark indicating an operation of "fast forwarding" is displayed at third push button part 20c. When the user presses down second push button part 20b, touch panel 22 receives an instruction of the playback and processor 12 described above plays back the music data.

As illustrated in FIG. 6, base part 38 of switch part 28 has a ring shape, and an outer diameter of base part 38 is smaller than a diameter of each of fixing-member through holes 26 and is larger than a diameter of each of cover-panel through holes 36. Further, a thickness of base part 38 in the x direction is equal to a thickness of fixing member 24 in the x direction. In this manner, base part 38 is disposed between cover panel 34 and touch panel 22 in each of fixing-member through holes 26.

An inner diameter of base part 38 is approximately the same as the diameter of each of cover-panel through holes 36. Switch part 28 has bent part 42 protruding from an inner edge on an operation surface side of base part 38 toward an inside of each of cover-panel through holes 36; and switch surface part 40 that is connected to an edge of bent part 42 on a side opposite to a side connected to base part 38 and that constitutes a pressing surface of switch part 28. Switch surface part 40 has a circular shape in the y-z plane, and a diameter of switch surface part 40 is smaller than the diameter of each of cover-panel through holes 36. Fixing member 30 is disposed on an operation surface side of switch surface part 40, and pressing part 32 is disposed on an operation surface side of fixing member 30. Fixing member 30 is formed of the same material as fixing member 24, and bonds switch surface part 40 and pressing part 32. Pressing part 32 and fixing member 30 are each formed into a circular shape having a diameter equal to the diameter of switch surface part 40 in the y-z plane. It is noted that shapes of switch surface part 40, fixing member 30, and pressing part 32 in a plan view are not limited to a circle, and can be selected freely from, for example, polygons such as a triangle and a square.

Pressing part 32 is fixed to switch surface part 40 of switch part 28 from a side opposite to touch panel 22 in this manner. Hereinafter, a surface on an operation surface side of pressing part 32 is referred to as an "operation surface of pressing part 32". Here, distance d1 between an outer edge of the operation surface of pressing part 32 and the operation surface of touch panel 22 in the x direction is set to coincide with distance d2 between the operation surface of cover panel 34 and the operation surface of touch panel 22 in the x direction. In other words, distance d1 coincides with distance d2 within a margin of error. By providing continuity between cover panel 34 and pressing part 32, a sense of unity between cover panel 34 and pressing part 32, that is, the flat design can be achieved.

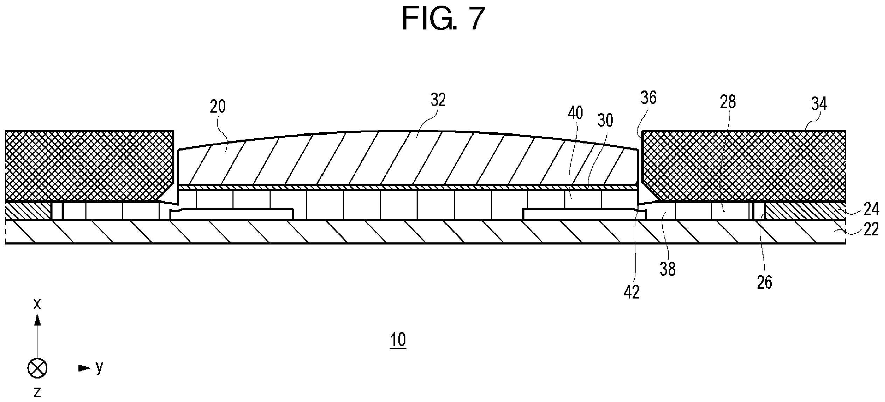

On the other hand, distance d3 between a central part of the operation surface of pressing part 32 and the operation surface of touch panel 22 is different from distance d1 described above. In this case, distance d3 is made lager than distance d1, and pressing part 32 is formed so as to be convex with respect to the operation surface of cover panel 34. With such a configuration, when the user presses down pressing part 32 in the negative direction of the x axis, push button-equipped touch panel 10 is deformed into a shape illustrated in FIG. 7. FIG. 7 is a cross-sectional view illustrating a configuration in a state where pressing part 32 is pressed down. When pressing force in the negative direction of the x axis is applied to pressing part 32, bent part 42 is deformed, thereby moving switch surface part 40 in the negative direction of the x axis. This movement provides the click feeling to the user. When the pressing force is removed, switch surface part 40 moves to an original position and push button-equipped touch panel 10 returns to the state illustrated in FIG. 6. FIG. 6 will be described again.

In FIG. 6, pressing part 32 and cover panel 34 are disposed on the same layer, and switch part 28 and fixing member 24 are disposed on the same layer. Here, each of the same layers is made of materials of the same type. By unifying factors such as color, refractivity, and transmissivity/reflectivity which affect appearances, a sense of unity is achieved in the appearances of cover panel 34 and push button parts 20, thereby showing as if push button parts 20 are not disposed. Pressing part 32 and cover panel 34 are made of materials of the same type, such as polycarbonate, glass, and acrylic. Switch part 28 and fixing member 24 are also made of materials of the same type. For example, switch part 28 is formed of silicon rubber and fixing member 24 is formed of silicon based tape. In this manner, in push button parts 20, pressing part 32 is formed of a material having hardness higher than that of switch part 28. This is because relatively soft materials are suitable for switch part 28 since switch part 28 needs to be deformed when pressed down by the user. In contrast, materials harder than switch part 28 are suitable for pressing part 32 since pressing part 32 is required to protect the display part and the touch panel, together with the cover panel. In the configuration of the first exemplary embodiment, pressing part 32 and cover panel 34 required to be hard are disposed on the same layer, and switch part 28 and fixing member 24 required to be soft are disposed on the same layer. Accordingly, satisfying the hardness required at each part and the design quality can be achieved at the same time.

Furthermore, a smoke color may be used for pressing part 32 and cover panel 34. Since transmissivity of light is lowered by use of the smoke color, a parting (clearance) between pressing part 32 and fixing member 24 is made inconspicuous when a display of display part 18 is turned off.

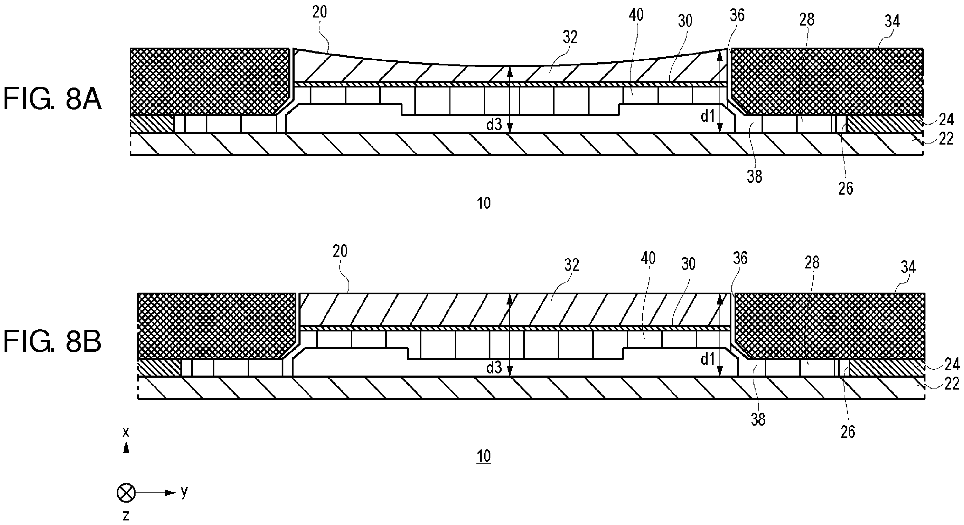

FIGS. 8A and 8B are cross-sectional views each illustrating a configuration of a variation of push button-equipped touch panel 10. Touch panels with push buttons 10 in FIGS. 8A and 8B are configured similar to FIG. 6, but are different from FIG. 6 in cross-sectional shapes of pressing parts 32. Similar to FIG. 6, distance d3 is different from distance d1 in FIG. 8A. However, in FIG. 8A, unlike FIG. 6, distance d3 is set smaller than distance d1, and pressing part 32 is formed so as to be concave with respect to the operation surface of cover panel 34. On the other hand, in FIG. 8B, distance d3 is set equal to distance d1, and pressing part 32 is formed so as to be flat with respect to the operation surface of cover panel 34.

According to the first exemplary embodiment of the present invention, the push button part is disposed in the cover-panel through hole of the cover panel disposed on the operation surface side of the touch panel. This reduces a portion protruding from the cover panel, in the push button part. Since the push button part is provided, the operability can be maintained. Also, the portion protruding from the cover panel in the push button part is reduced, thereby preventing the degradation in the design quality while maintaining the operability. Also, the push button part is configured by the switch part, fixing member, and the pressing part. Thus, the material suitable for each function can be selected. Since the material suitable for each function is selected, the operability is improved. Also, the distance between the outer edge of the pressing part and the operation surface of the touch panel is set to coincide with the distance between the operation surface of the cover panel and the operation surface of the touch panel, thereby achieving the flat design. Since the flat design is achieved, the degradation in the design quality can be prevented.

Also, the cross section of the pressing part has the convex shape with respect to the surface of the cover panel, and can be recognized by touch, thereby improving the operability. Also, the cross section of the pressing part has the concave shape with respect to the surface of the cover panel, and can be recognized by touch, thereby improving the operability. Also, the pressing part is flat with respect to the surface of the cover panel, thereby further improving the design quality. Since the flat design is achieved, a sense of incompatibility caused when a map or an image is displayed over an entire screen including the push button part can be prevented. The pressing part and the cover panel are formed of the materials of the same type, thereby improving the sense of unity. Also, the pressing part and the cover panel are configured to have the smoke color, thereby improving the sense of unity. Also, when the push button part is not used as the physical button, the push button part can be used as a typical touch panel, similar to the cover panel.

### SECOND EXEMPLARY EMBODIMENT

A second exemplary embodiment will be described. The second exemplary embodiment relates to the push button-equipped touch panel provided on the vehicle-mounted device, similar to the first exemplary embodiment. A push button-equipped touch panel according to the second exemplary embodiment is configured similar to the first exemplary embodiment, but aims to further make the parting (clearance) between the pressing part and the cover panel inconspicuous. For this purpose, in the second exemplary embodiment, anti-glare treatment is applied to surfaces and end surfaces of the pressing part and the cover panel. Vehicle-mounted device 100 according to the second exemplary embodiment is the same type as vehicle-mounted device 100 illustrated in FIG. 1 to FIG. 3, and push button-equipped touch panel 10 is the same type as push button-equipped touch panel 10 illustrated in FIG. 4 to FIG. 7. Herein, differences from the above exemplary embodiment will be mainly described.

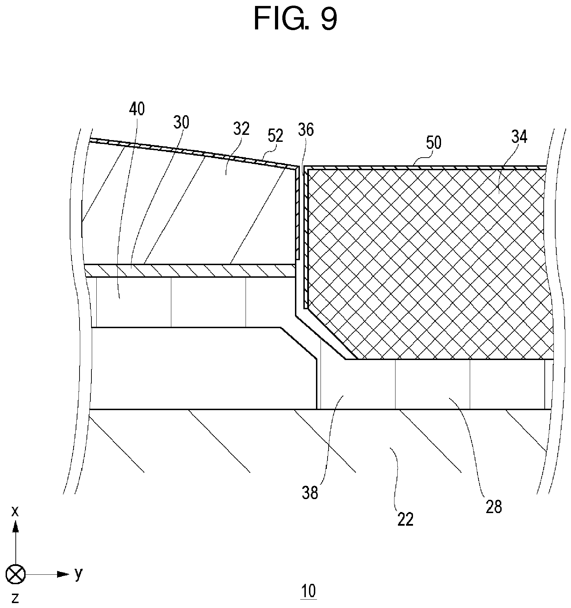

FIG. 9 is a partial cross-sectional view illustrating a configuration of push button-equipped touch panel 10 according to the second exemplary embodiment of the present invention. The cross-sectional view is illustrated while focusing on a portion between pressing part 32 and cover panel 34 in FIG. 6. As illustrated, first anti-glare surface 50 is disposed on the operation surface and on a side surface, which is at a side of pressing part 32, of cover panel 34. First anti-glare surface 50 is a surface subjected to the anti-glare treatment. Known techniques may be used for the anti-glare treatment, and therefore a description thereof is omitted herein, but machining or coating is performed as the anti-glare treatment. Also, second anti-glare surface 52 is disposed on the operation surface and on a side surface, which is at a side of cover panel 34, of pressing part 32. Second anti-glare surface 52 is formed in a manner similar to first anti-glare surface 50.

According to the second exemplary embodiment of the present invention, the anti-glare treatment is applied to the surface of the pressing part and the operation surface of the cover panel, thereby diffusing reflected light. Since the reflected light is diffused, a boundary between the push button part and the cover panel can be made inconspicuous. Also, since the boundary between the push button part and the cover panel is made inconspicuous, the sense of unity between the pressing part and the cover panel can be achieved.

### THIRD EXEMPLARY EMBODIMENT

A third exemplary embodiment will be described. The third exemplary embodiment relates to the push button-equipped touch panel provided on the vehicle-mounted device, similar to the above exemplary embodiments. A push button-equipped touch panel according to the third exemplary embodiment has an object for further making the parting (clearance) between the pressing part and the cover panel inconspicuous, similar to the second exemplary embodiment. For this purpose, in the third exemplary embodiment, a circularly polarizing plate is disposed between the pressing part and the switch surface part, and another circularly polarizing plate is disposed between the cover panel and the touch panel. Vehicle-mounted device 100 according to the third exemplary embodiment is the same type as vehicle-mounted device 100 illustrated in FIG. 1 to FIG. 3. Herein, differences from the above exemplary embodiments will be mainly described.

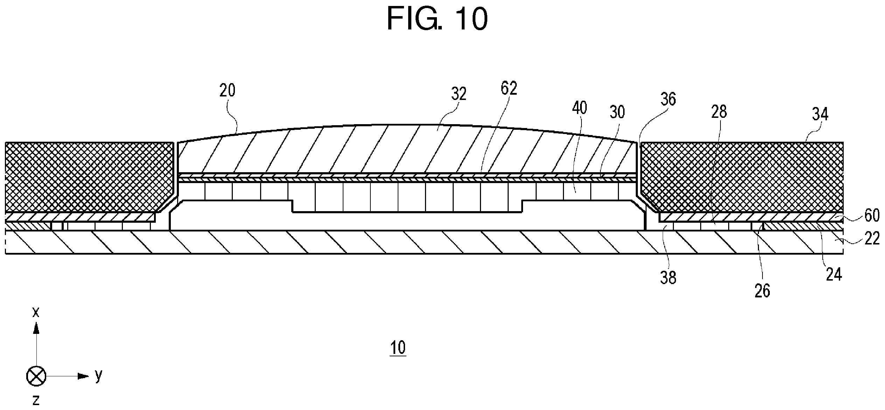

FIG. 10 is a cross-sectional view illustrating a configuration of push button-equipped touch panel 10 according to the third exemplary embodiment of the present invention. The cross-sectional view is illustrated similarly to FIG. 6. As described above, fixing member 24 is disposed on the operation surface side of touch panel 22, and first circularly polarizing plate 60 is disposed on the operation surface side of fixing member 24. Further, cover panel 34 is disposed on an operation surface side of first circularly polarizing plate 60. In other words, first circularly polarizing plate 60 is disposed between cover panel 34 and touch panel 22. It is noted that fixing member 24 and first circularly polarizing plate 60 may be disposed in a replaced manner. First circularly polarizing plate 60 circularly polarizes natural light input from a side of cover panel 34. First circularly polarizing plate 60 is configured by, for example, bonding a linearly polarizing film and a 1/4 phase difference film.

Fixing member 30 is disposed on the operation surface side of switch surface part 40, and second circularly polarizing plate 62 is disposed on the operation surface side of fixing member 30. Further, pressing part 32 is disposed on an operation surface side of second circularly polarizing plate 62. Therefore, second circularly polarizing plate 62 is disposed between pressing part 32 and switch surface part 40. It is noted that fixing member 30 and second circularly polarizing plate 62 may be disposed in a replaced manner. Second circularly polarizing plate 62 circularly polarizes natural light input from a side of pressing part 32. Second circularly polarizing plate 62 is configured in a similar way to first circularly polarizing plate 60.

According to the third exemplary embodiment of the present invention, the first circularly polarizing plate is disposed between the cover panel and the touch panel, and the second circularly polarizing plate is disposed between the pressing part and the switch surface part. Therefore, reflection of light between the touch panel and both the cover panel and the push button part can be prevented. Also, the reflection of light between the touch panel and both the cover panel and the push button part is prevented, thereby unifying the appearances of the cover panel and the push button part that are affected by the reflection of light.

In the third exemplary embodiment described above, operational sensitivity of touch panel 22 may be set so as to be sufficient at a region immediately below pressing part 32 where a distance between the operation surface of the touch panel and a surface touched by the user is large. With this configuration, sufficient operational sensitivity is obtained at regions other than the region immediately below pressing part 32.

The present invention has been described based on the exemplary embodiments. The exemplary embodiments are illustrative, and a person skilled in the art should understand that various variations can be achieved as combinations of each component or each processing process in the exemplary embodiments, and such variations fall within the scope of the present invention.

### REFERENCE MARKS IN THE DRAWINGS

- 2: windshield
- 4: steering wheel
- 6: driver's seat
- 8: passenger seat
- 10: push button-equipped touch panel
- 12: processor
- 14: storage
- 18: display part
- 20: push button part
- 20a: push button part
- 20b: push button part
- 20c: push button part
- 22: touch panel
- 24: fixing member
- 26: fixing-member through hole
- 26a: fixing-member through hole
- 26b: fixing-member through hole
- 26c: fixing-member through hole
- 28: switch part
- 30: fixing member
- 32: pressing part
- 34: cover panel
- 36: cover-panel through hole
- 36a: cover-panel through hole
- 36b: cover-panel through hole
- 36c: cover-panel through hole
- 38: base part
- 40: switch surface part
- 42: bent part
- 50: first anti-glare surface
- 52: second anti-glare surface
- 60: first circularly polarizing plate
- 62: second circularly polarizing plate
- 100: vehicle-mounted device

## Claims

1. A push button-equipped touch panel comprising:
a touch panel;
a cover panel that is disposed on an operation surface side of the touch panel, the cover panel having a through hole; and
a push button part disposed in the through hole of the cover panel.

2. The push button-equipped touch panel according to claim 1, further comprising a fixing member that fixes the cover panel to the touch panel, the fixing member having a through hole wider than the through hole of the cover panel,
wherein the push button part includes:
a switch part having
a base part disposed in the through hole of the fixing member, the base part being disposed between the cover panel and the touch panel,
a bent part protruding from an inner edge of the base part toward an inside of the through hole of the cover panel, and
a switch surface part that is connected to an edge of the bent part on a side opposite to a side connected to the base part and that constitutes a pressing surface; and
a pressing part fixed to the switch surface part of the switch part from a side opposite to the touch panel.

3. The push button-equipped touch panel according to claim 2, wherein a distance between an outer edge of the pressing part and an operation surface of the touch panel is set to coincide with a distance between an operation surface of the cover panel and the operation surface of the touch panel.

4. The push button-equipped touch panel according to claim 2 or 3, wherein a distance between a central part of the pressing part and the operation surface of the touch panel is different from the distance between the outer edge of the pressing part and the operation surface of the touch panel.

5. The push button-equipped touch panel according to any one of claims 2 to 4, wherein the pressing part and the cover panel are formed of materials of a same type.

6. The push button-equipped touch panel according to any one of claims 2 to 5, wherein anti-glare treatment is applied to a surface and an end surface of the pressing part, and the operation surface and an end surface of the cover panel.

7. The push button-equipped touch panel according to any one of claims 2 to 6, wherein the pressing part and the cover panel have a smoke color.

8. The push button-equipped touch panel according to any one of claims 2 to 7, further comprising:
a first circularly polarizing plate disposed between the cover panel and the touch panel; and
a second circularly polarizing plate disposed between the pressing part and the switch surface part.
